# EUROPEAN PATENT APPLICATION

(11) **EP 2 264 909 A1**
(43) Date of publication of application: **22.12.2010**
(21) Application number: 09721054.6
(22) Date of filing: 22.01.2009
(51) Int. Cl.: H04B 1/04, H03F 1/32, H04B 1/44

(54) **COMMUNICATION DEVICE, DISTORTION COMPENSATION CIRCUIT, AND DISTORTION COMPENSATION METHOD**

(30) Priority: 11.03.2008 JP 2008061428
(71) Applicant: NEC Corporation, Minato-ku Tokyo 108-8001 (JP)
(72) Inventor: AKAISHI, Makoto, Tokyo 108-8001 (JP)
(74) Representative: Glawe, Delfs, Moll
(86) International application number: PCT/JP2009/050949
(87) International publication number: WO 2009/113329

(57) **Abstract**

A transmission circuit sends a transmission signal from a signal-processing unit to a port. A reception circuit sends a received signal from a port to the signal-processing unit. A waveform monitor, by monitoring the waveform of the transmission signal that is sent to the port from the transmission circuit, generates a feedback signal. A switch unit connects the feedback signal from the waveform monitor to the reception circuit at transmission timing. The signal-processing unit compares the transmission signal with the feedback signal of the transmission signal.

## Description

### Technical Field

The present invention relates to a technology for detecting or compensating for the characteristics of transmission circuits in a communication apparatus provided with transmission circuits and reception circuits.

### Background Art

In a communication apparatus such as a radio base station of a mobile communication system, nonlinear distortion occurs in the transmission circuits. This nonlinear distortion chiefly occurs in the amplifier in the transmission circuits. Nonlinear distortion degrades the communication performance of the system and is therefore preferably detected and compensated for in the communication apparatus. As a result, communication apparatuses provided with the capability to compensate for nonlinear distortion are in use (refer to JP-A-2002-208979).

One typical nonlinear distortion-compensating circuit is of a configuration in which the output signal from the transmission circuits is fed back by means of a feedback circuit and compared with the input signal to the transmission circuits to detect the nonlinear distortion, and the input signal to the transmission circuits then compensated for based on the detected value of the nonlinear distortion.

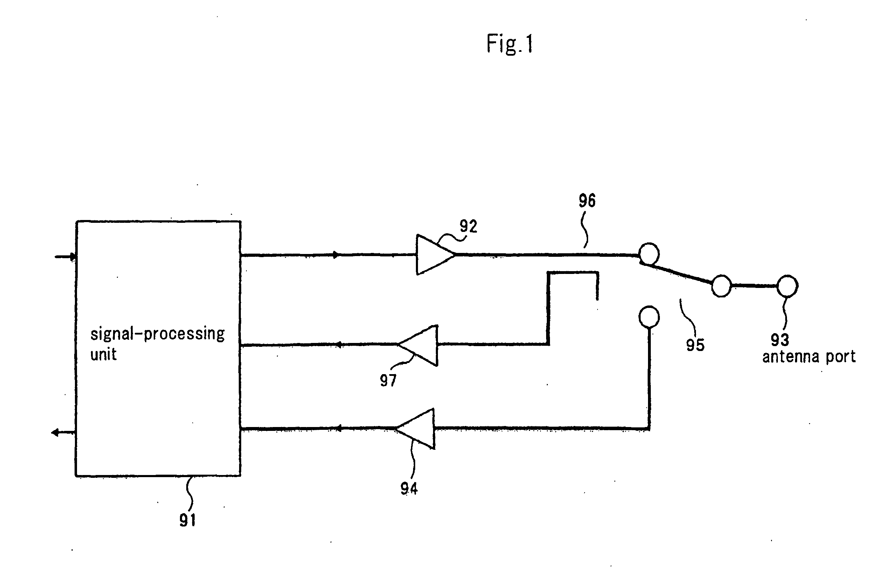

FIG. 1 is a block diagram showing an example of the configuration of a radio communication apparatus that has a typical nonlinear distortion-compensating circuit. According to the example, this radio communication apparatus is a communication apparatus that implements signal transmission and reception in time divisions. Referring to FIG. 1, the radio communication apparatus includes signal-processing unit 91, transmission amplifier 92, antenna port 93, reception amplifier 94, switch 95, waveform monitor 96, and feedback amplifier 97.

Signal-processing unit 91 carries out signal processing on the transmission side and reception side. On the transmission side, signal-processing unit 91 implements signal processing upon a transmission signal that is received as input and sends the transmission signal following signal processing to transmission amplifier 92. On the reception side, signal-processing unit 91 implements signal processing upon the received signal from reception amplifier 94 and supplies the received signal following signal processing as output. In addition, signal-processing unit 91 compares the feedback signal from feedback amplifier 97 with the transmission signal to detect nonlinear distortion produced in transmission amplifier 92 and subjects the transmission signal to compensation based on the detected value of nonlinear distortion.

Transmission amplifier 92 amplifies the transmission signal from signal-processing unit 91 and sends the transmission signal to switch 95. Transmission amplifier 92 requires great output power to transmit the transmission signal by radio. Transmission amplifier 92 for transmitting a transmission signal by radio typically operates in a state close to the saturation level and therefore tends to produce nonlinear distortion.

Switch 95 is a switch for switching between the transmission circuits and reception circuits in time divisions. Switch 95 connects antenna port 93 to transmission amplifier 92 at transmission timings and connects antenna port 93 to reception amplifier 94 at reception timings. The transmission signal from transmission amplifier 92 is sent to an antenna (not shown) from antenna port 93 by way of switch 95. In addition, the received signal from antenna port 93 is sent to reception amplifier 94 by way of switch 95.

Reception amplifier 94 amplifies the received signal from switch 95 that has been attenuated by radio transfer and sends the amplified signal to signal-processing unit 91.

Waveform monitor 96 monitors the transmission signal from transmission amplifier 92 and sends a feedback signal of the same waveform as the transmission signal to feedback amplifier 97. This feedback signal contains nonlinear distortion that occurred in transmission amplifier 92.

Feedback amplifier 97 amplifies the feedback signal from waveform monitor 96 and sends the amplified signal to signal-processing unit 91.

### Disclosure of the Invention

As can be understood by looking at FIG. 1, a radio communication apparatus having the capability to compensate for nonlinear distortion is provided with, in addition to transmission circuits that include transmission amplifier 92 and reception circuits that include reception amplifier 94, feedback circuits that include a feedback amplifier. These feedback circuits not only increase the circuit scale of the apparatus but also raise the cost of the apparatus.

It is an object of the present invention to provide a technique that enables detection or compensation for the characteristics of transmission circuits having a reduced circuit scale.

To achieve the above-described object, the communication apparatus according to one aspect of the present invention includes:
a signal-processing unit that subjects a transmission signal that is transmitted at transmission timings and a received signal that is received at reception timings of time divisions to predetermined signal processing, and that further compares the transmission signal with a feedback signal of the transmission signal;
transmission circuits for sending the transmission signal from the signal-processing unit to an external port;
reception circuits for sending the received signal from the external port to the signal-processing unit;
a waveform monitor that monitors the waveform of the transmission signal sent from the transmission circuits to the external port to generate the feedback signal; and
a switch unit that, at the transmission timings, both connects the transmission signal from the transmission circuits to the external port and connects the feedback signal from the waveform monitor to the reception circuits, and at the reception timings, connects the received signal from the external port to the reception circuits.

The distortion-compensating circuit according to an aspect of the present invention is provided with:
a signal-processing unit that both processes a received signal and transmission signal and compensates for distortion of the transmission signal that is supplied as output based on a feedback signal realized by feedback of the transmission signal that is supplied as output; and
common circuits that supply the received signal to the signal-processing unit during reception and feed back as a feedback signal to the signal-processing unit a portion of the transmission signal that was supplied as output from the signal-processing unit during transmission.

The distortion-compensating method according to one aspect of the present invention includes steps of:
by means of common circuits in a time division multiplexing communication apparatus, applying as input to a signal-processing unit that processes a received signal and a transmission signal the received signal during reception, and during transmission, applying as a feedback signal a portion of the transmission signal that is supplied as output from the signal-processing unit;
detecting a distortion amount from the feedback signal in the signal-processing unit; and
compensating for the distortion of the transmission signal based on the distortion amount in the signal-processing unit.

### Brief Description of the Drawings

FIG. 1 is a block diagram showing an example of the configuration of the radio communication apparatus that has a typical nonlinear distortion-compensating circuit;
FIG. 2 is a block diagram showing the configuration of the radio communication apparatus according to the first exemplary embodiment;
FIG. 3 shows the change in frequency spectrum of a transmission signal before and after transmission amplifier 12;
FIG. 4 shows the state of the switch at reception timings of the radio communication apparatus according to the first exemplary embodiment;
FIG. 5 is a block diagram showing the configuration of the radio communication apparatus according to the second exemplary embodiment;
FIG. 6 is a block diagram showing the configuration of the radio communication apparatus according to the third exemplary embodiment;
FIG. 7 is a block diagram showing the configuration of the radio communication apparatus according to the fourth exemplary embodiment;
FIG. 8 is a block diagram showing the configuration of the radio communication apparatus according to the fifth exemplary embodiment;
FIG. 9 is a block diagram showing the configuration of the radio communication apparatus according to the sixth exemplary embodiment; and
FIG. 10 is a block diagram showing the configuration of the radio base station apparatus according to the seventh exemplary embodiment.

### Best Mode for Carrying Out the Invention

Exemplary embodiments of the present invention are next described in detail with reference to the accompanying figures.

### First Exemplary Embodiment

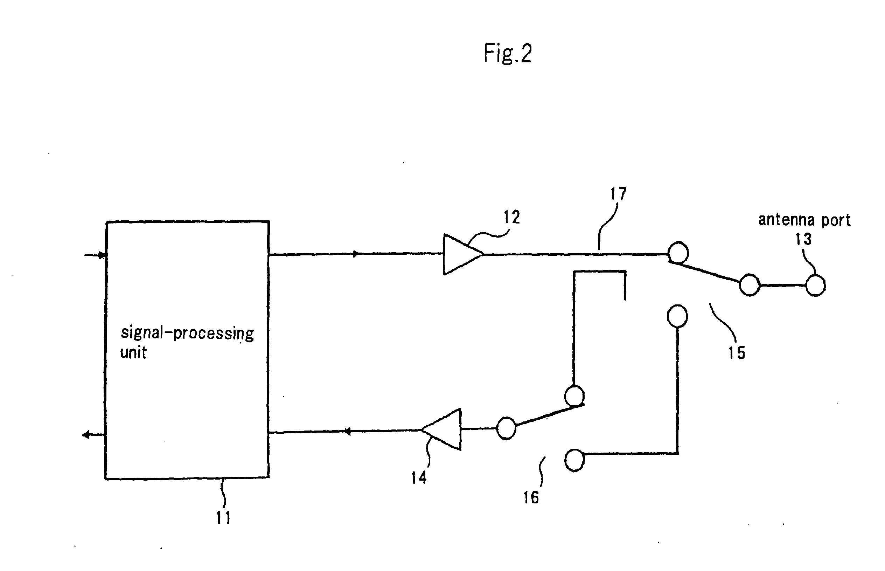

FIG. 2 is a block diagram showing the configuration of the radio communication apparatus according to the first exemplary embodiment. Referring to FIG. 2, the radio communication apparatus includes: signal-processing unit 11, transmission amplifier 12, antenna port 13, reception amplifier 14, switches 15 and 16, and waveform monitor 17. The present radio communication apparatus is an apparatus that switches between transmission timings and reception timings in time divisions. A WiMAX (Worldwide Interoperability for Microwave Access) base station apparatus is one example of this type of apparatus.

Signal-processing unit 11 carries out signal processing on the transmission side and the reception side. On the transmission side, signal-processing unit 11 subjects the transmission signal that is received as input from the left side of the figure to signal processing and sends the transmission signal following signal processing to transmission amplifier 12. On the reception side, signal-processing unit 11 subjects the received signal from reception amplifier 14 to signal processing and supplies the received signal following signal processing as output. In addition, signal-processing unit 11 compares the transmission signal with a feedback signal received as input from reception amplifier 14 at transmission timings to detect nonlinear distortion produced in transmission amplifier 12 and compensates for the transmission signal based on the detected value (distortion amount) of nonlinear distortion.

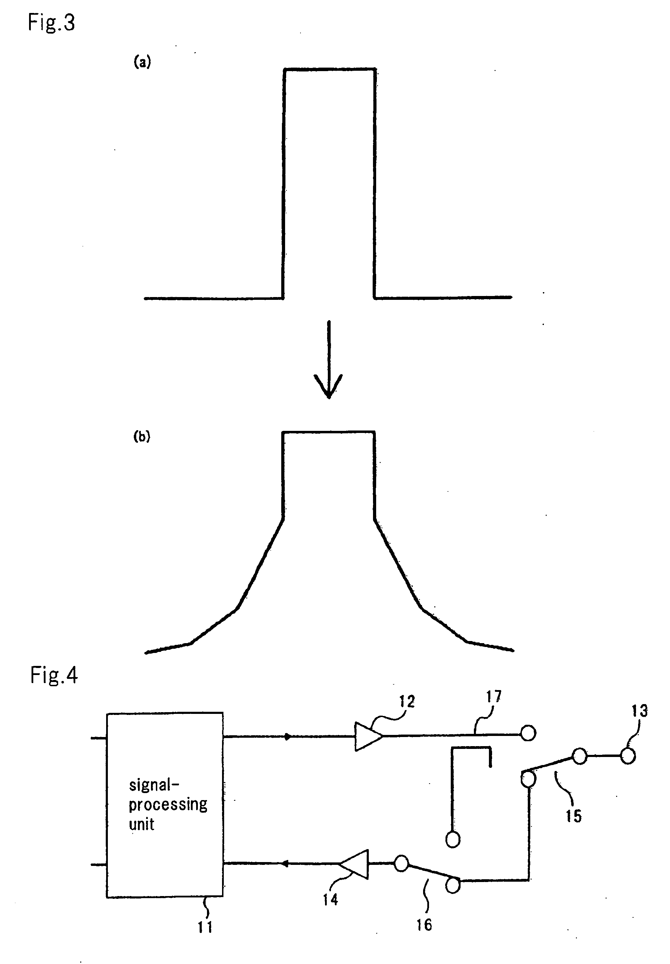

Transmission amplifier 12 amplifies the transmission signal from signal-processing unit 11 and sends the amplified signal to switch 15. Transmission amplifier 12 requires great output power for transmitting the transmission signal by radio. Transmission amplifier 12 for transmitting a transmission signal by radio typically operates in a state close to the saturation level and therefore tends to produce nonlinear distortion. Nonlinear distortion includes third-order distortion and fifth-order distortion. FIG. 3 shows changes in the frequency spectrum of a transmission signal before and after transmission amplifier 12 amplifies the signal. As shown in FIG. 3(a), distortion that was absent in the transmission signal before input to transmission amplifier 12 is included in the transmission signal after being supplied from transmission amplifier 12.

Switch 15 is a switch that switches between the transmission circuits and the reception circuits in time divisions. The transmission circuits are the circuits between signal-processing unit 11 and switch 15 and include transmission amplifier 12. The reception circuits are circuits between switch 16 and signal-processing unit 11 and include reception amplifier 14. For the sake of simplifying the explanation, other circuits or elements included in the transmission circuits and reception circuits are here omitted. Switch 15 connects antenna port 13 to transmission amplifier 12 at transmission timings and at reception timings connects antenna port 13 to switch 16 that is connected to reception amplifier 14.

Switch 16 is a switch that switches between transmission circuits and reception circuits in time divisions, similar to switch 15. Switch 16 connects waveform monitor 17 to reception amplifier 14 at transmission timings and connects antenna port 13 to reception amplifier 14 by way of switch 15 at reception timings. In this way, reception circuits between switch 16 and signal-processing unit 11 are common circuits that are used as feedback circuits during transmission and are used as reception circuit during reception.

Reception amplifier 14 amplifies the signal that is received as input and sends the amplified signal to signal-processing unit 11. At transmission timings, a feedback signal is received as input from waveform monitor 17, whereby reception amplifier 14 amplifies this signal. At reception timings, a received signal that has been attenuated by radio transfer is received as input from antenna port 13, and signal-processing unit 11 amplifies this signal.

Waveform monitor 17 monitors the transmission signal from transmission amplifier 12 and sends a feedback signal a waveform that is similar to the transmission signal to switch 16. This feedback signal contains nonlinear distortion that was generated in transmission amplifier 12.

Switching of the above-described switches 15 and 16 causes the transmission signal from signal-processing unit 11 to be amplified by transmission amplifier 12 and sent from antenna port 13 to an antenna (not shown) by way of switch 15 at transmission timings. At the same time, the feedback signal from waveform monitor 17 is amplified by reception amplifier 14 and is applied as input to signal-processing unit 11. At reception timings, the signal from antenna port 13 is amplified by reception amplifier 14 and applied as input to signal-processing unit 11. FIG. 2 shows switches 15 and 16 at a transmission timing. At reception timings, switches 15 and 16 are switched such as shown in FIG. 4.

According to the present exemplary embodiment, in a communication apparatus in which transmission timings and reception timings are switched in time divisions, feedback circuits that are converted from reception circuits at transmission timings apply a feedback signal as input to signal-processing unit 11 that carries out detection and compensation for nonlinear distortion, whereby nonlinear distortion can be compensated for by means of a small circuit scale.

### Second Exemplary Embodiment

The second exemplary embodiment is an example of a case in which a band-limiting filter is included in the reception circuit. In a radio communication system, adjacent frequencies of frequencies that are assigned to the system are sometimes used in other systems. In such cases, a band-limiting filter having a bandwidth of the same extent as the system's signal bandwidth is inserted into the reception circuit to eliminate signals of other systems.

A feedback signal for compensating for nonlinear distortion must contain nonlinear distortion such as third-order distortion or fifth-order distortion without alteration. However, when the reception circuits are used as the feedback circuits, including a band-limiting filter a bandwidth of the same extent as the system's signal bandwidth in the feedback circuits results in the elimination by the band-limiting filter of nonlinear distortion such as third-order distortion or fifth-order distortion that is necessary for compensating for the nonlinear distortion. As a result, the band-limiting filter is bypassed at the transmission timings in which the reception circuits are used as the feedback circuits in the present exemplary embodiment.

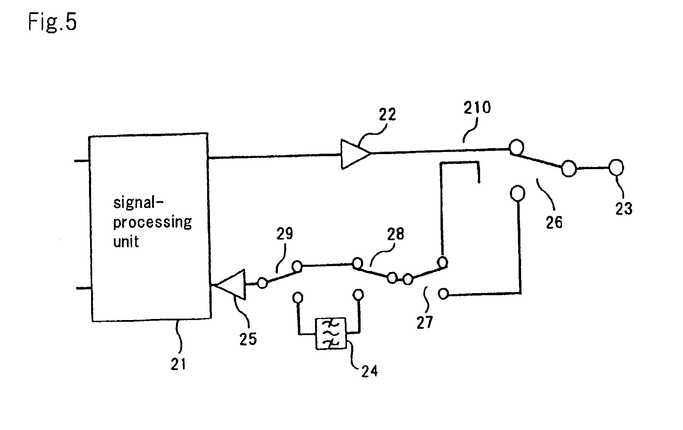

FIG. 5 is a block diagram showing the configuration of a radio communication apparatus according to the second exemplary embodiment. Referring to FIG. 5, the radio communication apparatus includes: signal-processing unit 21, transmission amplifier 22, antenna port 23, band-limiting filter 24, reception amplifier 25, switches 26-29, and waveform monitor 210.

Signal-processing unit 21 carries out transmission-side and reception-side signal processing. On the transmission side, signal-processing unit 21 subjects the transmission signal that is received as input to signal processing, and sends the transmission signal that follows signal processing to transmission amplifier 22. On the reception side, signal-processing unit 21 subjects the received signal from reception amplifier 25 to signal processing and supplies the received signal that follows signal processing as output. Signal-processing unit 21 compares the feedback signal that is received as input from reception amplifier 25 at transmission timings with the transmission signal to detect nonlinear distortion that is generated in transmission amplifier 22 and subjects the transmission signal to compensation based on the detected value of nonlinear distortion.

Transmission amplifier 22 amplifies the transmission signal from signal-processing unit 21 and sends the amplified signal to switch 26. Transmission amplifier 22 requires great output power for sending the transmission signal by radio. Typically, transmission amplifier 22 for sending a transmission signal by radio operates in a state close to saturation level and therefore tends to produce nonlinear distortion. Third-order distortion and fifth-order distortion are included in the nonlinear distortion.

Switch 26 is a switch that switches between the transmission circuits and reception circuits in time divisions. Switch 26 connects antenna port 23 and transmission amplifier 22 at transmission timings and connects antenna port 23 to switch 27 that is connected to reception amplifier 25 at reception timings.

Similar to switch 26, switch 27 is a switch that switches between the transmission circuits and reception circuits in time divisions. Switch 27 connects waveform monitor 210 to switch 28 at transmission timings and connects antenna port 23 to switch 28 by way of switch 26 at reception timings. In the present exemplary embodiment, reception circuits between switch 27 and signal-processing unit 21 are common circuits that are used as feedback circuits at the time of transmission and used as reception circuits at the time of reception. Band-limiting filter 24 in the common circuits is used only during reception timings in the present exemplary embodiment.

Band-limiting filter 24 is a filter for limiting the frequency band of the received signal and is inserted between switch 27 and reception amplifier 25 only at reception timings. At reception timings, band-limiting filter 24 limits the bandwidth of the received signal that is received as input from switch 26 by way of switch 27 and sends the band-limited signal to switch 29.

Reception amplifier 25 amplifies the received signal and sends the amplified signal to signal-processing unit 21. At transmission timings, a feedback signal from waveform monitor 210 is received as input, and reception amplifier 25 therefore amplifies this signal. At reception timings, a received signal from antenna port 23 that is attenuated by radio transfer is received as input, and reception amplifier 25 therefore amplifies this signal.

Similar to switches 26 and 27, switches 28 and 29 are switches for switching between the transmission circuits and reception circuits in time divisions. Switches 28 and 29 bypass band-limiting filter 24 and directly connect waveform monitor 210 to reception amplifier 25 at transmission timings, but at reception timings, are connected to the band-limiting filter 24 side and thus connect antenna port 23 to reception amplifier 25 by way of switches 26 and 27.

Waveform monitor 210 monitors the transmission signal from transmission amplifier 22 and sends to switch 27 a feedback signal having the same waveform as the transmission signal. This feedback signal contains nonlinear distortion that is produced by transmission amplifier 22.

By switching the above-described switches 26-29, the transmission signal from signal-processing unit 21 is amplified by transmission amplifier 22 and sent to an antenna (not shown) from antenna port 23 by way of switch 26 at transmission timings. In addition, the feedback signal from waveform monitor 210 is amplified by reception amplifier 25 and applied as input to signal-processing unit 21. At reception timings, the signal from antenna port 23 is filtered by band-limiting filter 24, amplified by reception amplifier 25, and applied as input to signal-processing unit 21.

According to the present exemplary embodiment, in a communication apparatus that is switched in time divisions at transmission timings and reception timings, band-limiting filter 24 is bypassed when the reception circuits are converted to feedback circuits at transmission timings, whereby nonlinear distortion can be accurately detected and compensated for in signal-processing unit 21 even when band-limiting filter 24 is included in the reception circuits.

### Third Exemplary Embodiment

The third exemplary embodiment is an example of a communication apparatus that implements double-conversion frequency conversion. An intermediate-frequency (IF) signal is used between the baseband signal used in the signal-processing unit and the radio frequency (RF) signal used in the radio lines. Processing of signals at each frequency signal level has been abbreviated in the interest of simplifying the explanation. As in the second exemplary embodiment, a band-limiting filter is present in the reception circuits in the present exemplary embodiment.

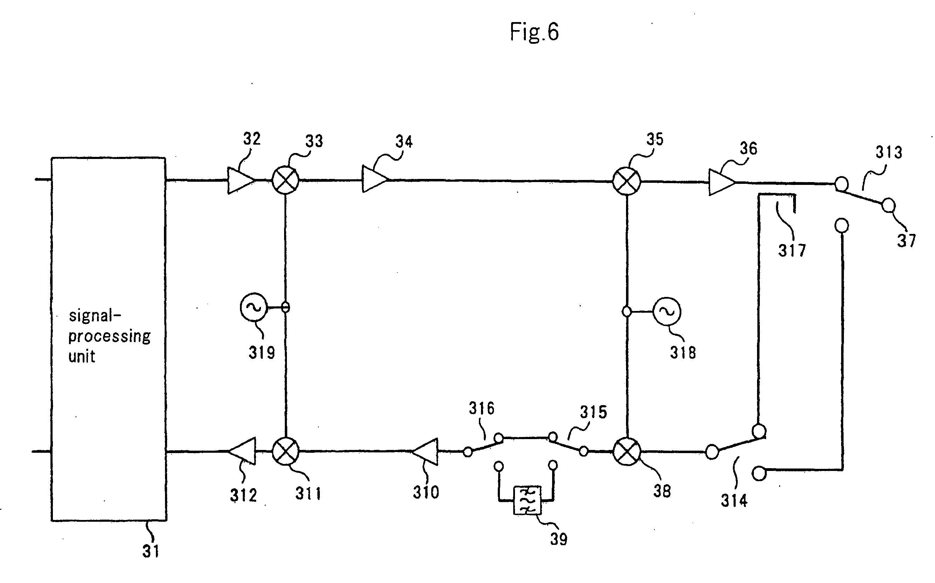

FIG. 6 is a block diagram showing the configuration of the radio communication apparatus according to the third exemplary embodiment. Referring to FIG. 6, the radio communication apparatus includes: signal-processing unit 31, transmission amplifiers 32, 34, and 36, transmission mixers 33 and 35, antenna port 37, reception mixers 38 and 311, band-limiting filter 39, reception amplifiers 310 and 312, waveform monitor 317, switches 313-316, and local oscillators 318 and 319.

Signal-processing unit 31 implements signal processing on the transmission side and reception side. On the transmission side, signal-processing unit 31 implements signal processing on a transmission signal that is received as input and sends the transmission signal following signal processing to transmission amplifier 32. On the reception side, signal-processing unit 31 implements signal processing on a received signal from reception amplifier 312 and supplies as output the received signal that follows the signal processing. At transmission timings, signal-processing unit 31 further compares a feedback signal that is received as input from reception amplifier 312 with the transmission signal to detect the nonlinear distortion that is produced in the transmission circuits (principally in transmission amplifier 36) and compensates for the transmission signal based on the detected value of the nonlinear distortion.

Transmission amplifier 32 amplifies the transmission signal from signal-processing unit 31 and sends the amplified signal to transmission mixer 33.

Transmission mixer 33 uses the frequency signal from local oscillator 319 to convert the frequency of the transmission signal from signal-processing unit 31 to the IF and sends the transmission signal that results from frequency conversion to transmission amplifier 34.

Transmission amplifier 34 amplifies the transmission signal from transmission mixer 33 and sends the amplified transmission signal to transmission mixer 35.

Transmission mixer 35 uses the frequency signal from local oscillator 318 to convert the frequency of the transmission signal from transmission amplifier 34 to the RF and sends the transmission signal that results from frequency conversion to transmission amplifier 36.

Transmission amplifier 36 amplifies the transmission signal from transmission mixer 35 and sends the amplified transmission signal to switch 313. This transmission amplifier 36 requires great output power to transmit the transmission signal by radio. A transmission amplifier typically operates in a state that approaches the saturation level to transmit a transmission signal by radio and therefore tends to produce nonlinear distortion. The nonlinear distortion contains third-order distortion and fifth-order distortion.

Switch 313 is a switch for switching between transmission circuits and reception circuits in time divisions. Switch 313 connects antenna port 37 to transmission amplifier 36 at transmission timings and connects antenna port 37 to switch 314 at reception timings.

Similar to switch 313, switch 314 is a switch for switching between transmission circuits and reception circuits in time divisions. Switch 314 connects waveform monitor 317 to reception mixer 38 at transmission timings, and connects switch 313 that is connected to antenna port 37 to reception mixer 38 at reception timings. In the present exemplary embodiment, reception circuits between switch 314 and signal-processing unit 31 are common circuits that are used as feedback circuits during transmission and used as reception circuits during reception. In the present exemplary embodiment, band-limiting filter 39 in the common circuits is used only at reception timings.

Reception mixer 38 uses the frequency signal from local oscillator 318 to convert the frequency of the signal received as input from switch 314 to the IF and sends the signal resulting from frequency conversion to switch 315. At transmission timings, the feedback signal from waveform monitor 317 is received as input, and reception mixer 38 therefore converts the frequency of this feedback signal. At reception timings, the received signal from antenna port 37 that is attenuated by radio transmission is received as input, and reception mixer 38 therefore converts the frequency of this received signal.

Band-limiting filter 39 is inserted in the reception circuits only at reception timings, and after limiting the band of the signal from reception mixer 38 by way of switch 315, sends the band-limited signal to reception amplifier 310 by way of switch 316.

Reception amplifier 310 amplifies the signal received as input from switch 316 and sends the amplified signal to reception mixer 311. A feedback signal is supplied as output from switch 316 at transmission timings, and the received signal is supplied as input at reception timings.

Reception mixer 311 uses a frequency signal from local oscillator 319 to further convert the frequency of the signal from reception amplifier 310 and sends the signal resulting from frequency conversion to reception amplifier 312. This reception mixer 311 converts the IF frequency that was converted by reception mixer 38 to the even lower IF frequency.

Reception amplifier 312 amplifies the signal from reception mixer 311 and sends the amplified signal to signal-processing unit 31.

Similar to switches 313 and 314, switches 315 and 316 are switches for switching between transmission circuits and reception circuits in time divisions. Switches 315 and 316 bypass band-limiting filter 39 and directly connect reception mixer 38 to reception amplifier 310 at transmission timings and insert band-limiting filter 39 between reception mixer 38 and reception amplifier 310 at reception timings.

Waveform monitor 317 monitors the transmission signal from transmission amplifier 36 and sends a feedback signal having the same waveform as the transmission signal to switch 314. This feedback signal contains nonlinear distortion that is produced in transmission amplifier 36.

The switching of the above-described switches 313-316 causes the transmission signal to be amplified in transmission amplifier 36 at transmission timings and to be sent from antenna port 37 to an antenna (not shown) by way of switch 313, and further, causes the feedback signal from waveform monitor 317 to be applied as input to signal-processing unit 31 without passing by way of band-limiting filter 39. At reception timings, the signal from antenna port 37 is subjected to filtering in band-limiting filter 39 and applied as input to signal-processing unit 31.

In the present exemplary embodiment as described hereinabove, because transmission amplifier 36 of the RF is the chief source of nonlinear distortion, waveform monitor 317 is provided in the output of transmission amplifier 36. Because reception mixer 38, reception amplifier 310, mixer 311, and reception amplifier 312 are shared by the reception circuits and feedback circuits, compensation for nonlinear distortion can be realized with a small circuit scale. In addition, nonlinear distortion can be accurately detected and compensated for even when band-limiting filter 39 is included in the reception circuits.

### Fourth Exemplary Embodiment

As in the third exemplary embodiment, the fourth exemplary embodiment is a case of a communication apparatus that effects double-conversion frequency conversion. An intermediate frequency (IF) is used between the baseband signal used in the signal-processing unit and the radio frequency (RF) signal used in the radio lines. The processing of signals at each frequency signal level is abbreviated for the sake of simplifying the explanation.

In the present exemplary embodiment, however, a reception amplifier for level adjustment is located at the position of the band-limiting filter in the third exemplary embodiment. This reception amplifier is bypassed when the reception circuits are used as feedback circuits. This configuration takes into consideration the configuration of an apparatus in which the level of the feedback signal is higher than the received signal that has been attenuated on radio lines. In the communication apparatus of the present exemplary embodiment, the basic apparatus configuration is otherwise the same as that of the third exemplary embodiment.

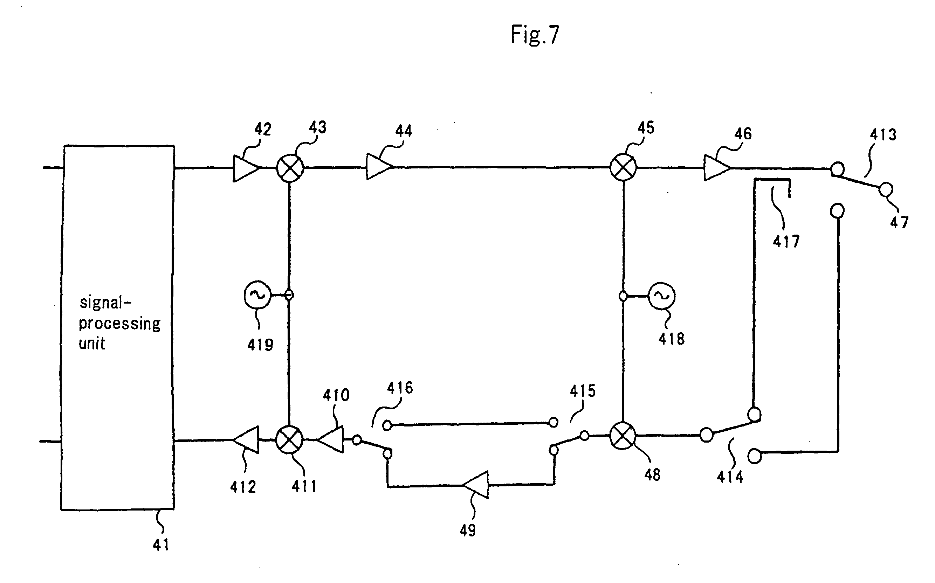

FIG. 7 is a block diagram showing the configuration of the radio communication apparatus according to the fourth exemplary embodiment. Referring to FIG. 7, the radio communication apparatus includes: signal-processing unit 41, transmission amplifiers 42, 44, and 46, transmission mixers 43 and 45, antenna port 47, reception mixers 48 and 411, reception amplifiers 49, 410, and 412, waveform monitor 417, switches 413-416, and local oscillators 418 and 419. In the present exemplary embodiment, reception circuits between switch 414 and signal-processing unit 41 are common circuits that are used as feedback circuits during transmission and used as reception circuits during reception.

Signal-processing unit 41, transmission amplifiers 42, 44, and 46, transmission mixers 43 and 45, antenna port 47, reception mixers 48 and 411, reception amplifiers 410 and 412, waveform monitor 417, switches 413-416, and local oscillators 418 and 419 each correspond to signal-processing unit 31, transmission amplifiers 32, 34, and 36, transmission mixers 33 and 35, antenna port 37, reception mixers 38 and 311, reception amplifiers 310 and 312, waveform monitor 317, switches 313-316, and local oscillators 318 and 319, respectively, of the third exemplary embodiment. Switches 415 and 416 bypass reception amplifier 49 and directly connect reception mixer 48 to reception amplifier 410 at transmission timings, and insert reception amplifier 49 between reception mixer 48 and reception amplifier 410 at reception timings. This configuration causes reception amplifier 49 that is used for adjusting the level of a received signal to be bypassed when the reception circuits are used as feedback circuits.

### Fifth Exemplary Embodiment

As in the third and fourth exemplary embodiments, the fifth exemplary embodiment is an example of a communication apparatus that effects double-conversion frequency conversion.

In the present exemplary embodiment, however, both the band-limiting filter and reception amplifier are bypassed when the reception circuits are used as feedback circuits. The reason for bypassing the band-limiting filter is the same as the reason for bypassing the band-limiting filter in the third exemplary embodiment. The reason for bypassing the reception amplifier is the same as the reason for bypassing the reception amplifier in the fourth exemplary embodiment.

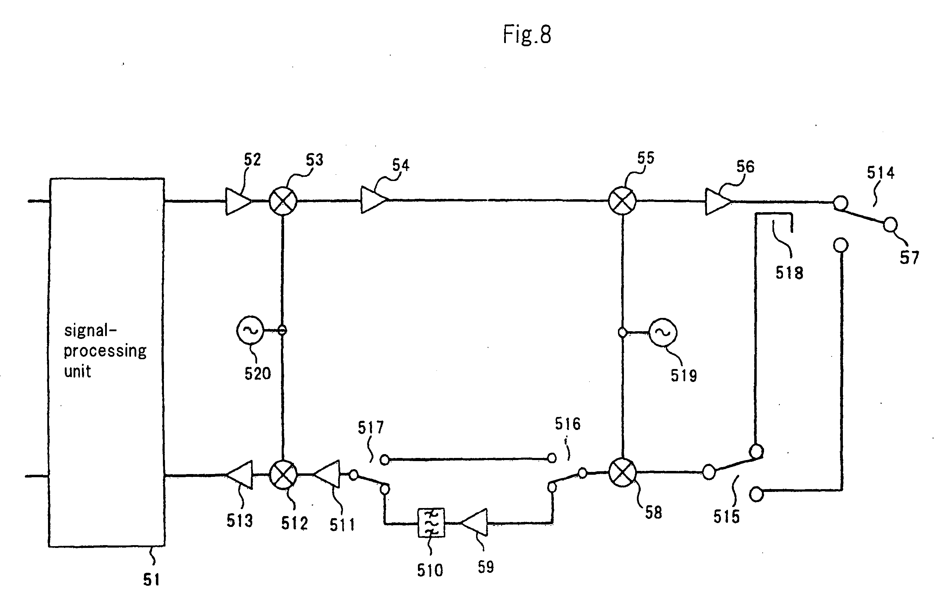

FIG. 8 is a block diagram showing the configuration of the radio communication apparatus according to fifth exemplary embodiment. Referring to FIG. 8, the radio communication apparatus includes: signal-processing unit 51, transmission amplifiers 52, 54, and 56, transmission mixers 53 and 55, antenna port 57, reception mixers 58 and 512, reception amplifiers 59, 511, and 513; band-limiting filter 510, waveform monitor 518, switches 514-517, and local oscillators 519 and 520. In the present exemplary embodiment, reception circuits located between switch 515 and signal-processing unit 51 are common circuits that are used as feedback circuits during transmission and used as reception circuits during reception.

Each of signal-processing unit 51, transmission amplifiers 52, 54, and 56, transmission mixers 53 and 55, antenna port 57, reception mixers 58 and 512, reception amplifiers 511 and 513, waveform monitor 518, switches 514-517, and local oscillators 519 and 520 correspond to signal-processing unit 31, transmission amplifiers 32, 34, and 36, transmission mixers 33 and 35, antenna port 37, reception mixers 38 and 311, reception amplifiers 310 and 312, waveform monitor 317, switches 313-316, and local oscillators 318 and 319, respectively, of the third exemplary embodiment. According to this configuration, reception amplifier 59 for adjusting the level of the received signal and band-limiting filter 510 for limiting the bandwidth of the received signal are bypassed when the reception circuits are used as feedback circuits, as in the fourth exemplary embodiment.

### Sixth Exemplary Embodiment

As in the third to fifth exemplary embodiments, the sixth exemplary embodiment is an example of a communication apparatus that effects double-conversion frequency conversion. In the present exemplary embodiment, however, reception mixers for frequency conversion from RF to IF are provided in each of the reception circuits and feedback circuits.

In addition, as in the fifth exemplary embodiment, when the reception circuits are used as feedback circuits in the present exemplary embodiment, the band-limiting filter and reception amplifier are both bypassed. As another example, however, a configuration is also possible in which one of the band-limiting filter and reception amplifier is bypassed.

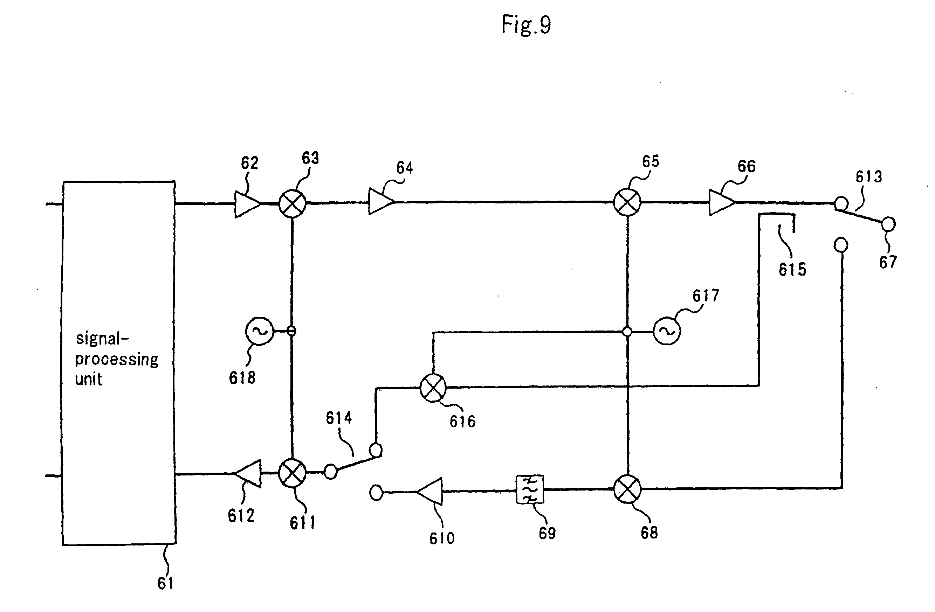

FIG. 9 is a block diagram showing the configuration of the radio communication apparatus according to the sixth exemplary embodiment. Referring to FIG. 9, the radio communication apparatus includes: signal-processing unit 61, transmission amplifiers 62, 64, and 66, transmission mixers 63 and 65, antenna port 67, reception mixers 68 and 611, reception amplifiers 610 and 612, band-limiting filter 69, waveform monitor 615, feedback mixer 616, switches 613 and 614, and local oscillators 617 and 618. In the present exemplary embodiment, circuits located between switch 614 and signal-processing unit 61 are common circuits that are used as feedback circuits during transmission and used as reception circuits during reception.

Signal-processing unit 61 effects signal processing on the transmission side and reception side. In addition, at transmission timings, signal-processing unit 61 compares a feedback signal received as input from reception amplifier 612 with the transmission signal to detect nonlinear distortion that is produced in the transmission circuits and implements compensation for the transmission signal based on the detected value of nonlinear distortion.

Transmission amplifier 62 amplifies the transmission signal from signal-processing unit 61 and sends the amplified signal to transmission mixer 63.

Transmission mixer 63 uses the frequency signal from local oscillator 618 to convert the frequency of the transmission signal from signal-processing unit 61 to the IF and then sends the transmission signal following frequency conversion to transmission amplifier 64.

Transmission amplifier 64 amplifies the transmission signal from transmission mixer 63 and sends the amplified signal to transmission mixer 65.

Transmission mixer 65 uses the frequency signal from local oscillator 617 to convert the frequency of the transmission signal from transmission amplifier 64 to the RF and then sends the transmission signal that follows frequency conversion to transmission amplifier 66.

Transmission amplifier 66 amplifies the transmission signal from transmission mixer 65 and sends the amplified signal to switch 613. This transmission amplifier 66 is the chief source of the production of nonlinear distortion, as in the other exemplary embodiments.

Reception mixer 68 uses the frequency signal from local oscillator 617 to convert the frequency of the received signal that is received as input from switch 613 to the IF and sends the received signal that follows frequency conversion to band-limiting filter 69.

Band-limiting filter 69 limits the bandwidth of the received signal from reception mixer 68 and sends the signal to reception amplifier 610.

Reception amplifier 610 amplifies the signal that is received as input from band-limiting filter 69 and sends the signal to switch 614.

Similar to switch 613, switch 614 is a switch for switching between the transmission circuits and reception circuits in time divisions. Switch 614 connects feedback mixer 616 to reception mixer 611 at transmission timings and connects reception amplifier 610 to reception mixer 611 at reception timings.

Reception mixer 611 uses the frequency signal from local oscillator 618 to further convert the frequency of the signal from switch 614 and sends the signal following frequency conversion to reception amplifier 612.

Reception amplifier 612 amplifies the signal from reception mixer 611 and sends the signal to signal-processing unit 61.

Waveform monitor 615 monitors the transmission signal from transmission amplifier 66 and sends a feedback signal having the same waveform as the transmission signal to feedback mixer 616. This feedback signal includes the nonlinear distortion that is produced in transmission amplifier 66.

Feedback mixer 616 converts the frequency of the feedback signal from waveform monitor 615 and sends the feedback signal that follows frequency conversion to switch 614.

The above-described switching of switches 613 and 614 causes the transmission signal to be amplified by transmission amplifier 66 and sent to an antenna (not shown) from antenna port 67 by way of switch 613 at transmission timings, and further, causes the feedback signal from waveform monitor 615 to be applied as input to signal-processing unit 61 without passage through band-limiting filter 69 and reception amplifier 610. At reception timings, the signal from antenna port 67 is subjected to filtering at band-limiting filter 69, undergoes level adjustment at reception amplifier 610, and is then applied as input to signal-processing unit 61.

The present exemplary embodiment has the effect of enabling a reduction of the number of switches compared to the third to fifth exemplary embodiments. In addition, the present exemplary embodiment has the further effect of improving circuit reliability and operation stability due to the reduced number of sites of operation.

### Seventh Exemplary Embodiment

The communication apparatuses of the first to sixth exemplary embodiments are configurations assumed to be outdoor units of a radio base station. An outdoor unit of a radio base station is used connected to an indoor unit. However, the present invention can also be applied to an integrated radio base station that is provided with the functions of an outdoor unit and indoor unit.

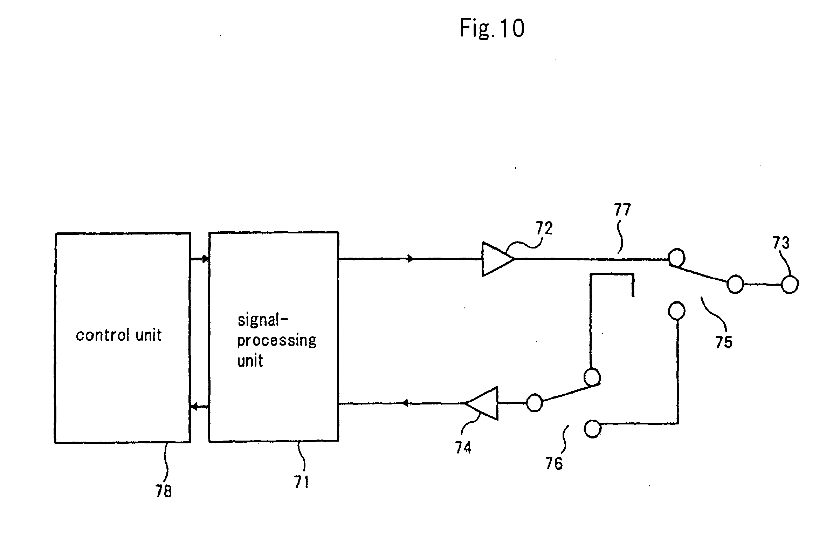

The communication apparatus of the seventh exemplary embodiment is an integrated radio base station apparatus provided with control functions that include radio resource management and mobile management. FIG. 10 is a block diagram showing the configuration of the radio base station apparatus according to the seventh exemplary embodiment. Referring to FIG. 10, the radio base station apparatus includes signal-processing unit 71, transmission amplifier 72, antenna port 73, reception amplifier 74, switches 75 and 76, waveform monitor 77, and control unit 78.

Signal-processing unit 71, transmission amplifier 72, antenna port 73, reception amplifier 74, switches 75 and 76, and waveform monitor 77 each correspond to signal-processing unit 11, transmission amplifier 12, antenna port 13, reception amplifier 14, switches 15 and 16, and waveform monitor 17, respectively, of the first exemplary embodiment.

Control unit 78 carries out radio resource management that is used in connecting with a mobile station (not shown) by radio lines by way of antenna port 73 and mobile management of each mobile station that is connected by radio lines. At this time, control unit 78 transmits and receives control signals with each mobile station. In addition, control unit 78 carries out relaying of user data that are transmitted and received between each mobile station and a host apparatus (not shown).

Although an integrated radio base station apparatus that corresponds to the radio communication apparatus of the first exemplary embodiment is shown by way of example in the present exemplary embodiment, the present invention is not limited to this form. Radio base station apparatuses corresponding to the radio communication apparatuses of the second to sixth exemplary embodiments can also be similarly configured.

Although exemplary embodiments of the present invention have been described hereinabove, the present invention is not limited to only these exemplary embodiments and these exemplary embodiments may be used in combination or portions of the configurations may be modified within the scope of the technical idea of the present invention.

Although the present invention has been described hereinabove with reference to exemplary embodiments, the present invention is not limited to these exemplary embodiments. The configuration and details of the present invention as defined in the claims are open to various modifications within the scope of the invention that will be understood by one of ordinary skill in the art.

This application claims the benefits of priority based on JP-A-2008-061428 for which application was submitted on March 11, 2008 and incorporates all of the citations disclosed therein.

## Claims

1. A communication apparatus comprising:
a signal-processing unit that subjects a transmission signal that is transmitted at transmission timing and a received signal that is received at reception timing in time divisions to predetermined signal processing, and further, that compares said transmission signal with a feedback signal of said transmission signal;
a transmission circuit for sending the transmission signal from said signal-processing unit to an external port;
a reception circuit for sending the received signal from said external port to said signal-processing unit;
a waveform monitor that monitors the waveform of the transmission signal sent from said transmission circuit to said external port to generate said feedback signal; and
a switch unit that, at said transmission timing, both connects said transmission signal from said transmission circuit to said external port and connects said feedback signal from said waveform monitor to said reception circuit, and at said reception timing; connects said received signal from said external port to said reception circuit.

2. The communication apparatus as set forth in claim 1, wherein said switch unit, when connecting said feedback signal from said waveform monitor to said reception circuit at said transmission timing, bypasses a portion of said reception circuit.

3. The communication apparatus as set forth in claim 2, wherein:
said reception circuit includes a band-limiting filter for limiting the bandwidth of said received signal; and
said switch unit bypasses said band-limiting filter in said reception circuit when said feedback signal from said waveform monitor is connected to said reception circuit at said transmission timing.

4. The communication apparatus as set forth in claim 2, wherein:
said reception circuit includes a reception amplifier for adjusting level; and
said switch unit bypasses said reception amplifier in said reception circuit when said feedback signal from said waveform monitor is connected to said reception circuit at said transmission timing.

5. The communication apparatus as set forth in any one of claims 1 to 4, wherein:
said transmission circuit includes a transmission mixer for converting the frequency of said transmission signal;
said reception circuit includes a reception mixer for converting the frequency of said received signal;
said waveform monitor monitors said transmission signal at a position that follows said transmission mixer; and
said switch unit connects said feedback signal from said waveform monitor to a position preceding said reception mixer of said reception circuit.

6. The communication apparatus according to any one of claims 1 to 4, wherein:
said transmission circuit includes a transmission mixer for converting the frequency of said transmission signal;
said reception circuit includes a reception mixer for converting the frequency of said reception signal;
said communication apparatus further comprises a feedback mixer for converting the frequency of said feedback signal from said waveform monitor;
said waveform monitor monitors said transmission signal at a position that follows said transmission mixer; and
said switch unit connects said feedback signal from said waveform monitor to a position that follows said reception mixer of said reception circuit.

7. The communication apparatus as set forth in any one of claims 1 to 6, wherein said signal-processing unit, by comparing said transmission signal and said feedback signal, detects nonlinear distortion that occurs in said transmission signal in said transmission circuit.

8. The communication apparatus as set forth in claim 7, wherein said signal-processing unit, based on said nonlinear distortion that was detected, compensates for said transmission signal that is sent to said transmission circuit.

9. The communication apparatus as set forth in any one of claims 1 to 8, wherein said communication apparatus is a radio communication apparatus and said external port is an antenna port connected to an antenna.

10. The communication apparatus as set forth in claim 9, further comprising a control unit that performs transmission and reception with said signal-processing unit of control signals and user data relating to mobile stations connected by radio lines.

11. A distortion-compensating circuit in a time division multiplexing communication apparatus, comprising:
a signal-processing unit that both processes a received signal and a transmission signal and, based on a feedback signal realized by feedback of said transmission signal that is supplied as output, compensates for distortion of said transmission signal that is supplied as output; and
a common circuit that supplies said received signal to said signal-processing unit during reception, and during transmission, feeds back as a feedback signal to said signal-processing unit a portion of said transmission signal that was supplied as output from said signal-processing unit.

12. The distortion-compensating circuit as set forth in claim 11, further comprising switching means that transmits in time division multiplexing manner said reception signal during reception and said feedback signal during transmission to said common circuit.

13. The distortion-compensating circuit as set forth in claim 12, wherein said switching means is a switch that switches the connection destination of said antenna.

14. The distortion-compensating circuit as set forth in any one of claims 11 to 13, wherein said common circuit is provided with: a band-limiting filter that limits the bandwidth of said received signal and then transmits said received signal to said signal-processing unit during reception, and bypass means that during transmission bypasses said band-limiting filter and transmits said feedback signal to said signal-processing unit without limiting bandwidth.

15. The distortion-compensating circuit as set forth in any one of claims 11 to 13, wherein said common circuit is provided with an amplifier that amplifies said received signal during reception and then transmits said received signal to said signal-processing unit and bypass means that bypasses said amplifier during transmission and transmits said feedback signal to said signal-processing unit without amplifying said feedback signal.

16. The distortion-compensating circuit as set forth in any one of claims 11 to 15, wherein said common circuit is provided with an amplifier for transmission for transmitting said transmission signal by radio and feedback means that feeds back a portion of said transmission signal that was supplied from said amplifier for transmission.

17. The distortion-compensating circuit as set forth in claim 16, wherein said feedback means is a waveform monitor that monitors said transmission signal.

18. The distortion-compensating circuit as set forth in claims 11 to 17, wherein said common circuit is provided with a common amplifier that amplifies said received signal during reception and amplifies said feedback signal during transmission.

19. A distortion compensation method comprising steps of:
by means of common circuit in a time division multiplexing communication apparatus, applying as input to a signal-processing unit that processes a received signal and a transmission signal, said received signal during reception, and during transmission, applying as a feedback signal a portion of said transmission signal that is supplied as output from said signal-processing unit;
detecting a distortion amount from said feedback signal in said signal-processing unit; and
compensating for distortion of said transmission signal based on said distortion amount in said signal-processing unit.

20. The distortion compensation method as set forth in claim 19, wherein said distortion amount is detected by comparing said feedback signal with said transmission signal.

21. The distortion compensation method as set forth in claim 19 or claim 20, wherein said signal-processing unit processes said received signal and said transmission signal in time divisions.

22. The distortion compensation method as set forth in claims 19 to 21, wherein said received signal is subjected to bandwidth-limiting and sent to said signal-processing unit during reception, but during transmission, said feedback signal is sent to said signal-processing unit without undergoing bandwidth-limiting.

23. The distortion compensation method as set forth in claims 19 to 22, wherein said received signal is amplified and sent to said signal-processing unit during reception, but during transmission, said feedback signal is transmitted to said signal-processing unit without being amplified.

## Amended claims

### Amended claims under Art. 19.1 PCT

**1.** (Deleted)

**2.** (Deleted)

**3.** (Deleted)

**4.** (Deleted)

**5.** (Deleted)

**6.** (Deleted)

**7.** (Deleted)

**8.** (Deleted)

**9.** (Deleted)

**10.** (Deleted)

**11.** (Amended) A distortion-compensating circuit in a time division multiplexing communication apparatus, said distortion-compensating circuit comprising:
a signal-processing unit that both processes a received signal and a transmission signal and, based on a feedback signal realized by feedback of said transmission signal that is supplied as output, compensates for distortion of said transmission signal that is supplied as output; and
a common circuit that supplies said received signal to said signal-processing unit during reception, and during transmission, feeds back as a feedback signal to said signal-processing unit a portion of said transmission signal that was supplied as output from said signal-processing unit;
wherein:
said common circuit is provided with: a band-limiting filter that during reception limits the bandwidth of said received signal and then sends said received signal to said signal-processing unit; and bypass means that during transmission bypasses said band-limiting filter and sends said feedback signal to said signal-processing unit without limiting the bandwidth of said feedback signal.

**12.** The distortion-compensating circuit as set forth in claim 11, further comprising switching means that transmits in time division multiplexing manner said reception signal during reception and said feedback signal during transmission to said common circuit.

**13.** The distortion-compensating circuit as set forth in claim 12, wherein said switching means is a switch that switches the connection destination of said antenna.

**14.** (Deleted)

**15.** (Amended) The distortion-compensating circuit as set forth in any one of claims 11 to 13, wherein:
said common circuit is further provided with an amplifier that during reception amplifies said received signal and then transmits said received signal to said signal-processing unit; and said bypass means during transmission bypasses both said band-limiting filter and said amplifier and transmits said feedback signal to said signal-processing unit without amplifying said feedback signal.

**16.** (Amended) The distortion-compensating circuit as set forth in any one of claims 11 to 13 and 15, wherein said common circuit is provided with an amplifier for transmission for transmitting said transmission signal by radio and feedback means that feeds back a portion of said transmission signal that was supplied as output from said amplifier for transmission.

**17.** The distortion-compensating circuit as set forth in claim 16, wherein said feedback means is a waveform monitor that monitors said transmission signal.

**18.** (Amended) The distortion-compensating circuit as set forth in claims 11 to 13 and 15 to 17, wherein said common circuit is provided with a common amplifier that amplifies said received signal during reception and amplifies said feedback signal during transmission.

**19.** (Amended) A distortion compensation method comprising steps of:
by means of a common circuit provided with a band-limiting filter that limits the bandwidth of a received signal and that transmits to a signal-processing unit in a time division multiplexing communication apparatus, limiting the bandwidth of said received signal and then applying said received signal as input to said signal-processing unit that processes said received signal and a transmission signal during reception, and during transmission, bypassing said band-limiting filter and applying as a feedback signal a portion of said transmission signal that is supplied as output from said signal-processing unit without limiting the bandwidth of said feedback signal;
detecting a distortion amount from said feedback signal in said signal-processing unit;
and
compensating for distortion of said transmission signal based on said distortion amount in said signal-processing unit.

**20.** The distortion compensation method as set forth in claim 19, wherein said distortion amount is detected by comparing said feedback signal with said transmission signal.

**21.** The distortion compensation method as set forth in claim 19 or claim 20, wherein said signal-processing unit processes said received signal and said transmission signal in time divisions.

**22.** The distortion compensation method as set forth in claims 19 to 21, wherein said received signal is subjected to bandwidth-limiting and sent to said signal-processing unit during reception, but during transmission, said feedback signal is sent to said signal-processing unit without undergoing bandwidth-limiting.

**23.** The distortion compensation method as set forth in claims 19 to 22, wherein said received signal is amplified and sent to said signal-processing unit during reception, but during transmission, said feedback signal is transmitted to said signal-processing unit without being amplified.

**24.** (Added) The distortion compensation method as set forth in any one of claims 19 to 23, wherein, by means of switching means, said received signal during reception and said feedback signal during transmission are transmitted in time division multiplexing manner to said common circuit.

**25.** (Added) The distortion compensation method as set forth in claim 24, wherein said switch means is a switch that switches the connection destination of an antenna.

**26.** (Added) The distortion compensation method as set forth in any one of claims 19 to 24, wherein:
said common circuit is further provided with an amplifier, and by means of the amplifier, said received signal is amplified and transmitted to said signal-processing unit during reception; and
during transmission, both said band-limiting filter and said amplifier are bypassed and said feedback signal is transmitted to said signal-processing unit without being amplified

**27.** (Added) The distortion compensation method as set forth in any one of claims 19 to 26, wherein:
said common circuit is further provided with an amplifier for transmission, and by means of the amplifier for transmission, said transmission is transmitted; and
said feedback means feeds back a portion of said transmission signal that was supplied as output from said amplifier for transmission.

**28.** (Added) The distortion compensation method as set forth in claim 27, wherein said feedback means is a waveform monitor that monitors said transmission signal.

**29.** (Added) The distortion compensation method as set forth in any one of claims 19 to 28, wherein said common circuit is further provided with a common amplifier, and by means of the common amplifier, said received signal is amplified during reception and said feedback signal is amplified during transmission.
